(19) Europäisches Patentamt
European Patent Office
Office européen des brevets

(11) **EP 1 225 697 A2**

(12) **EUROPEAN PATENT APPLICATION**

(43) Date of publication:
**24.07.2002 Bulletin 2002/30**

(51) Int Cl.⁷: **H03J 5/24**

(21) Application number: **02000401.6**

(22) Date of filing: **07.01.2002**

| | |
|---|---|
| (84) Designated Contracting States:<br>**AT BE CH CY DE DK ES FI FR GB GR IE IT LI LU<br>MC NL PT SE TR**<br>Designated Extension States:<br>**AL LT LV MK RO SI**<br><br>(30) Priority: **12.01.2001 JP 2001004502**<br><br>(71) Applicant: **NEC CORPORATION**<br>**Tokyo (JP)** | (72) Inventor: **Takaki, Tetsuya**<br>**Minato-ku, Tokyo (JP)**<br><br>(74) Representative: **Betten & Resch**<br>**Patentanwälte,**<br>**Theatinerstrasse 8**<br>**80333 München (DE)** |

(54) **Method and circuit for avoiding band interference wave in receiver**

(57)    In a method of avoiding a band interference wave which is produced in a receiver when a reception frequency used for radio communication is converted into a fixed intermediate frequency by using the oscillation frequency of a local signal oscillator, when the frequency of a reception signal is on the low-frequency side in a reception frequency band, channel setting and route switching control are so performed as to make the reception signal pass through a low-pass filter. A circuit for avoiding a band interference wave is also disclosed.

FIG.5

EP 1 225 697 A2

## Description

## BACKGROUND OF THE INVENTION

FIELD OF THE INVENTION:

The present invention relates to a method and circuit for avoiding band interference waves in a receiver which are produced when the reception frequency used for radio communication is converted into a fixed intermediate frequency (IF) by using the oscillation frequency of a local signal oscillator and, more particularly, to a method and circuit for avoiding interference waves produced in a /12 IF spurious band in a receiver.

DESCRIPTION OF THE PRIOR ART:

In general, in a radio receiver circuit used in radio communication, after a reception signal in an RF band is frequency-converted into a reception signal in an IF band by using a frequency converter which is a component of the receiver, a baseband reception signal is generated from the reception signal in the IF band by using an quadrature demodulator which is a component of the receiver. Subsequently, the receiver demodulates the obtained baseband reception signal, and extracts data such as speech and image data from the demodulated reception signal. Receivers used in radio communication can be classified according to the number of times of frequency conversion from the RF band to the IF band. A receiver designed to perform frequency conversion once is called a heterodyne receiver, whereas a receiver designed to perform frequency conversion twice is called a double-heterodyne receiver.

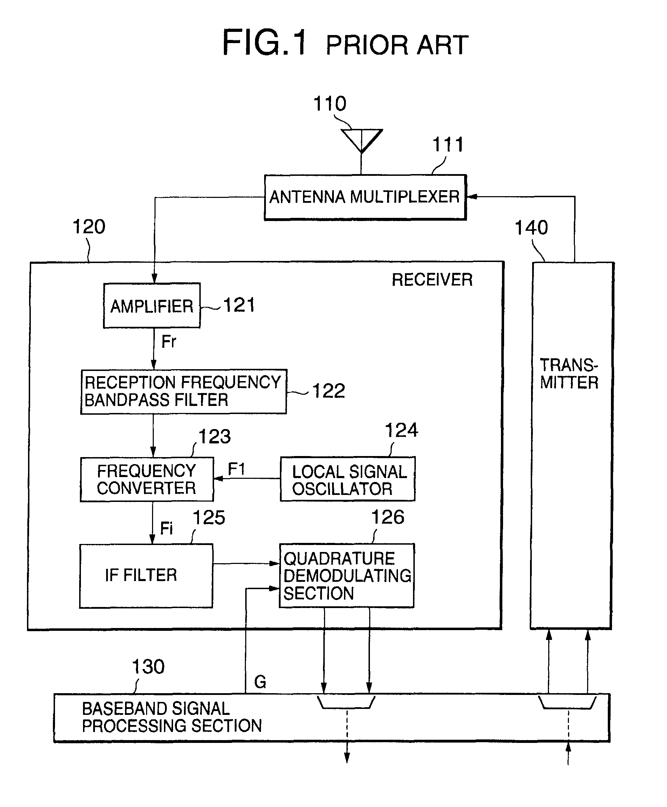

A conventional heterodyne receiver will be described with reference to Fig. 1.

Fig. 1 shows a radio unit comprised of a receiver 120 for receiving a reception signal in the RF band from an antenna multiplexer 111 connected to an antenna 110 and frequency-converting the reception signal into a baseband reception signal, a baseband signal processing section 130, and a transmitter 140.

In the receiver 120, an amplifier 121 amplifies a signal in the RF band which is received by the antenna 110 and separated by the bandpass filter of the antenna multiplexer 111, and a reception frequency bandpass filter 122 passes only a signal having a reception frequency Fr, of the reception signal, which is channel-set in the RF band. A frequency converter 123 frequency-converts the reception signal having the reception frequency Fr into a reception signal in the band of intermediate frequencies Fi by using the local oscillation frequency F1 received from a local signal oscillator 124. An IF filter 125 then passes only the reception signal having the intermediate frequency Fi.

A quadrature demodulating section 126 receives a gain control signal G fed back from the baseband signal processing section 130, and controls the gain of the reception signal to a predetermined value. In addition, the quadrature demodulating section 126 performs quadrature demodulation of the reception signal. The baseband signal processing section 130 frequency-converts the reception signal in the IF band into a baseband reception signal.

The occurrence of frequencies which become interference waves in the receiver will be described next.

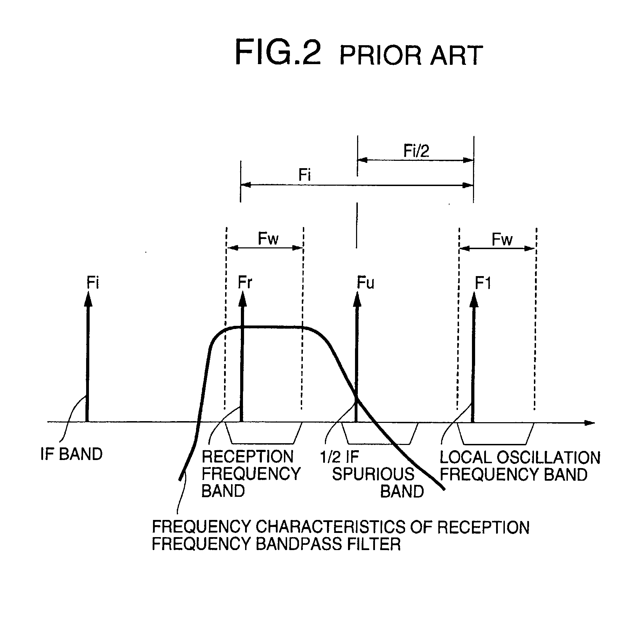

Referring to Figs. 1 and 2, the frequency converter 123 inputs two signals having different frequencies to a nonlinear circuit for frequency conversion. The frequencies output upon inputting of these signals include sum and difference frequencies between the two input different frequencies as well as the reception frequency Fr as an input frequency and the local oscillation frequency F1. It is generally known that the frequency converter 123 is formed by an active element and has nonlinear characteristics. If the frequency of the reception signal in the IF band output from the frequency converter 123 is represented by an intermediate frequency Fi, the respective frequencies have the following relationship:

$$Fi = F1 - Fr \qquad (1)$$

The frequency converter 123 frequency-converts a reception signal in the RF band (frequency Fr) into a reception signal in the IF band (frequency Fi) by using the relationship expressed by equation (1).

However, since the frequency converter 123 is an active element having nonlinear characteristics, second and third harmonic waves due to nonlinear distortion are also output.

The second and third harmonic waves have the following influences.

Assume that the receiver 120 has simultaneously received the reception frequency Fr and an interference wave Fu having the frequency relationship based on equation (2) given below:

$$Fu = F1 - Fi/2 \qquad (2)$$

An output frequency Fui of the interference wave Fu in the IF band is obtained by replacing the frequencies Fi and Fr in equations (1) and (2) with the frequencies Fui and Fu, and equation (3) given below holds:

$$Fui = F1 - Fu$$

$$= F1 - (F1 - Fi/2)$$

$$= Fi/2 \qquad (3)$$

The second harmonic wave of this output frequency Fui

is expressed by

$$2 \times Fui = 2 \times (Fi/2)$$
$$= Fi \qquad (4)$$

That is, the second harmonic wave of the output frequency Fui falls within the band of intermediate frequencies Fi. This problem is called a 1/2 IF spurious problem, which is known as a cause of a deterioration in reception sensitivity.

For example, general known methods of preventing a deterioration in reception sensitivity due to a 1/2 IF spurious component are to improve the cutoff characteristics of the antenna multiplexer 111 and reception frequency bandpass filter 122 in the 1/2 IF spurious band and to improve the distortion characteristics of the frequency converter 123.

The latter method, i.e., improving the distortion characteristics of the frequency converter 123, can be realized by increasing the current consumption of the frequency converter 123. Recently, however, many receivers used for radio communication are battery-driven as portable units. Therefore, as the current consumption increases, the battery operating time of the receiver shortens. This technique is not therefore regarded as a subject to be considered for improvement.

As another technique, a reception circuit is disclosed in Japanese Unexamined Patent Publication No. 1-1666626. In this reception circuit, as shown in Fig. 3, a low-pass filter 202 and high-pass filter 203 are switched by switches 201 and 204 in accordance with a reception frequency to prevent interference waves which are produced when the first intermediate frequency is not set to a frequency twice or more the maximum reception frequency in the double-superheterodyne scheme. That is, it is an object of this technique to prevent interference waves under a condition in which the sum of the reception frequency Fr and the interference wave frequency Fu becomes the first intermediate frequency.

This reception circuit includes the low-pass filter 202 and high-pass filter 203 and receives a signal by switching reception bands by using the switches 201 and 204. In this arrangement, the frequency of a first local signal oscillator 207 is so changed as to set frequencies Fil/2 and Fih/2, which are 1/2 first intermediate frequencies Fil and Fih converted by a first frequency converter 206, as the inhibition bands of the low-pass filter 202 and high-pass filter 203 used for reception. In addition, a second frequency converter 212 converts the first intermediate frequencies Fil and Fih into a single second frequency Fi2 by changing the frequency of a second local signal oscillator 213.

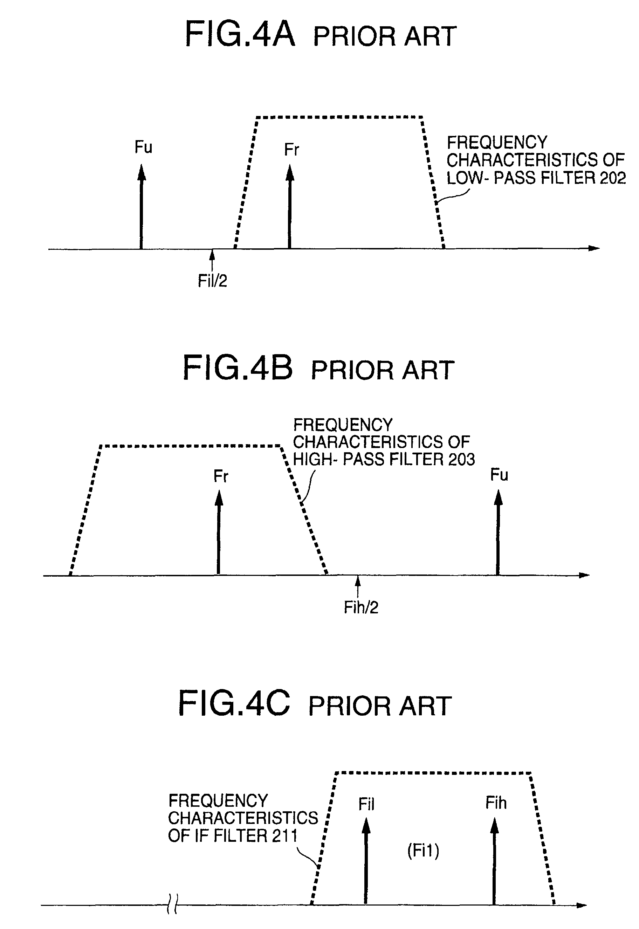

As shown in Figs. 4A to 4C, the frequency characteristics of the low-pass filter 202 exhibit a higher frequency band to inhibit the frequency Fil/2 on the low-frequency side, whereas the frequency characteristics of the high-pass filter 203 exhibit a lower frequency band to inhibit the frequency Fih/2 on the low-frequency side.

The conventional receiver described with reference to Fig. 1 suffers the problem of a deterioration in reception sensitivity called the 1/2 IF spurious problem.

An example of a method of preventing a deterioration in reception sensitivity due to the 1/2 IF spurious problem is to improve the cutoff characteristics of antenna multiplexer 111 and reception frequency bandpass filter 122 in the 1/2 IF spurious band.

A problem in this method will be described with reference to Figs. 1 and 2.

It is generally known that the band of reception frequencies Fr is set to a bandwidth Fw of a relatively broadband in order to ensure a sufficient communication line or communication capacity. This is because in the band of intermediate frequencies Fi, in order to extract only a reception channel, only one intermediate frequency Fi is set so as not to have a bandwidth exceeding the channel width.

As shown in Fig. 2, to pass a reception signal without any loss, the antenna multiplexer 111 and reception frequency bandpass filter 122 need to have bandwidths equal to or larger than the bandwidth Fw. If, however, the band of local oscillation frequencies F1 is near the reception frequency Fr, i.e., the band of intermediate frequencies Fi is low, the 1/2 IF spurious band also approaches the band of reception frequencies Fr.

In this case, the antenna multiplexer 111 and reception frequency bandpass filter 122 cannot satisfactorily cut off the 1/2 IF spurious band. That is, sufficient cutoff characteristics in the 1/2 IF spurious band cannot be ensured for the antenna multiplexer 111 and reception frequency bandpass filter 122. When the receiver receives the lowest reception frequency Fr in the reception frequency band as shown in Fig. 2, in particular, the interference wave frequency Fu due to 1/2 IF spurious component approaches the reception frequency band most. As a consequence, it cannot be expected that the antenna multiplexer 111 and reception frequency bandpass filter 122 will cut off or attenuate interference waves.

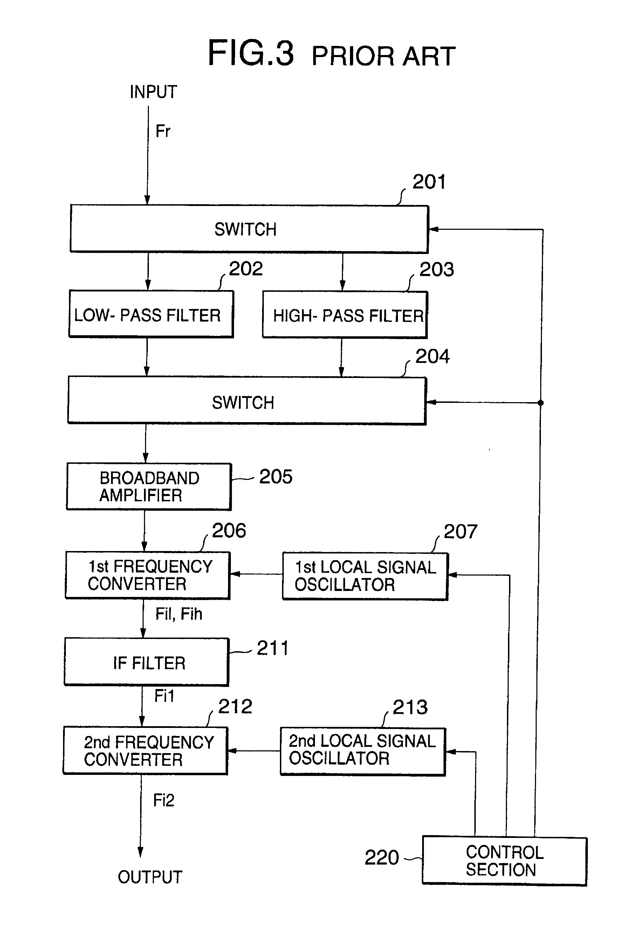

According to the reception circuit described with reference to Fig. 3, as described with reference to Figs. 4A to 4C, the frequencies Fil/2 and Fih/2, which are 1/2 the first intermediate frequencies Fil and Fih, are set outside the frequency characteristics of the low-pass filter 202 and high-pass filter 203 with respect to the two reception frequency bands to prevent the occurrence of interference waves under the condition in which the sum of the reception frequency Fr and the interference wave frequency Fu becomes the first intermediate frequencies Fi1 and Fih. Therefore, this circuit is not intended to inhibit the interference wave frequency Fu produced by the oscillation frequency of the local signal oscillator and the frequency Fi/2 that is 1/2 the intermediate frequency, as indicated by equation (2).

## SUMMARY OF THE INVENTION

The present invention has been made in consideration of the above situation, and has as its object to provide a method and circuit for avoiding interference waves in a 1/2 IF spurious band in a receiver which can prevent, in a reception frequency band, an interference frequency Fu originating from the difference between an oscillation frequency F1 of a local signal oscillator and a frequency Fi/2 that is 1/2 an intermediate frequency.

As is obvious, passing of the interference waves Fu in the 1/2 IF spurious band can be prevented by narrowing the bandwidth of a reception frequency bandpass filter at least on the low-frequency side in a bandwidth Fw shown in Fig. 2. Therefore, the following means are taken by using the technique of providing a plurality of reception frequency bandpass filters, which is disclosed in the above reference.

In order to achieve the above object, according to the first aspect of the present invention, there is provided a method of avoiding a band interference wave which is produced in a receiver when a reception frequency used for radio communication is converted into a fixed intermediate frequency by using an oscillation frequency of a local signal oscillator, wherein when a frequency of a reception signal is on a low-frequency side in a reception frequency band, channel setting and route switching control are so performed as to make the reception signal pass through a low-pass filter.

According to the second aspect of the present invention, there is provided a method of avoiding a band interference wave which is produced in a receiver when a reception frequency used for radio communication is converted into a fixed intermediate frequency by using an oscillation frequency of a local signal oscillator, comprising the steps of setting bandwidths of a plurality of bandpass filters for dividing a band of reception frequencies such that a frequency of a band interference wave produced by the oscillation frequency of the local signal oscillator falls outside a pass band, and switching one of the plurality of bandpass filters to a bandpass filter corresponding to the frequency of the reception signal.

According to the third aspect of the present invention, the frequency outside the pass band in the second aspect is preferably a frequency obtained by adding a frequency 1/2 an intermediate frequency to a lowest frequency in each of the bands of the bandpass filters.

According to the fourth aspect of the present invention, there is provided a circuit for avoiding a band interference wave which is produced in a receiver when a reception frequency used for radio communication is converted into a fixed intermediate frequency by using an oscillation frequency of a local signal oscillator, comprising bandpass filters for dividing a band of reception frequencies into a plurality of narrow bands, and a switch for switching the bandpass filters in accordance with a reception frequency of a reception signal corresponding to a set channel, wherein the plurality of bandpass filters respectively have frequency characteristics which set bandwidths such that a frequency of a band interference wave produced by the oscillation frequency of the local signal oscillator falls outside a pass band.

According to the fifth aspect of the present invention, each of the bandwidths of the plurality of bandpass filters in the fourth aspect is preferably set such that a frequency obtained by adding a frequency 1/2 an intermediate frequency to a lowest frequency in each of the bands falls outside the pass band.

According to the sixth aspect of the present invention, there is provided a circuit for avoiding a band interference wave which is produced in a receiver when a reception frequency used for radio communication is converted into a fixed intermediate frequency by using an oscillation frequency of a local signal oscillator, comprising a plurality of bandpass filters which divide a band of reception frequencies into a plurality of narrow bands, and respectively have bandwidths set such that a frequency obtained by adding a frequency 1/2 the intermediate frequency to a lowest reception frequency in each band falls outside a pass band, a switch for switching the bandpass filters in accordance with a reception frequency, and a local signal oscillator for generating a fixed intermediate frequency by changing a generated oscillation frequency in accordance with a reception frequency.

As is obvious from each embodiment described above, according to the present invention, even if the receiver receives interference waves based on a 1/2 IF spurious component which causes a deterioration in reception sensitivity concurrently with a reception signal, no deterioration in reception sensitivity occurs, and excellent radio communication can be performed.

This is because at least a bandpass filter on the low-frequency side is separately provided with respect to the reception frequency band. As a consequence, even if interference waves due to the 1/2 IF spurious component are close to the reception frequency band, the frequency characteristic of the low-frequency side bandpass filter can be sufficiently separated from the 1/2 IF spurious frequency band, and the 1/2 IF spurious frequency band can be made to fall in the complete cutoff range of the low-frequency side bandpass filter.

The above and many other objects, features and advantages of the present invention will become manifest to those skilled in the art upon making reference to the following detailed description and accompanying drawings in which preferred embodiments incorporating the principle of the present invention are shown by way of illustrative examples.

## BRIEF DESCRIPTION OF THE DRAWINGS

Fig. 1 is a functional block diagram showing an example of a conventional receiver;

Fig. 2 is a graph showing an example of the positional relationship between frequency bands handled by the receiver in Fig. 1;

Fig. 3 is a functional block diagram showing another example of a conventional receiver different from that shown in Fig. 1;

Figs. 4A to 4C are graphs each showing an example of the positional relationship between the frequency characteristics of a bandpass filter handed in a reception circuit in Fig. 3 and an interference frequency;

Fig. 5 is a functional block diagram showing an embodiment of the receiver according to the present invention;

Fig. 6 is a functional block diagram showing a detailed example of part of the receiver in Fig. 5; and

Fig. 7 is a graph showing an example of the positional relationship between frequency bands handled in the receiver according to the present invention.

## DETAILED DESCRIPTION OF THE PREFERRED EMBODIMENT

A preferred embodiment of the present invention will be described below with reference to the accompanying drawings.

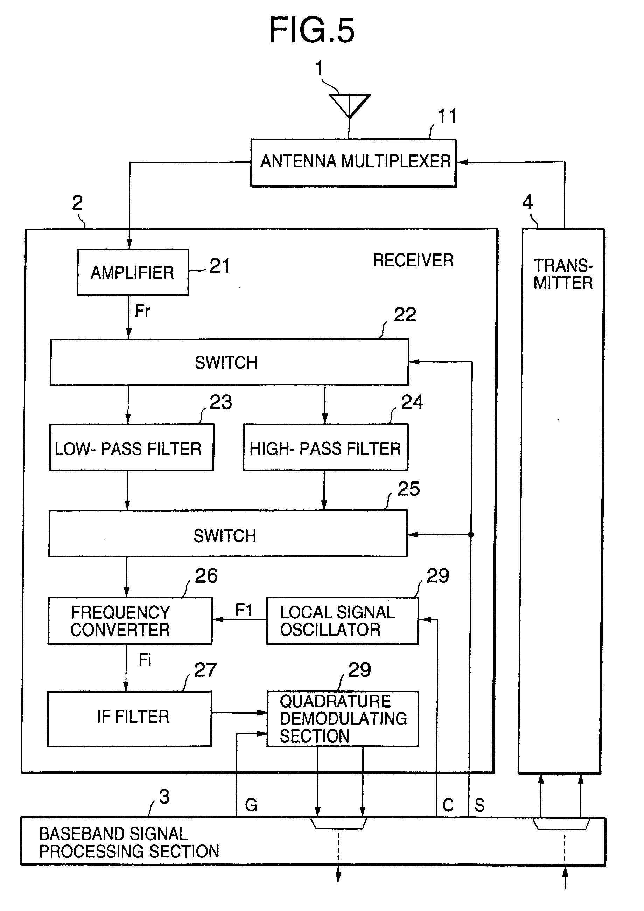

Fig. 5 is a functional block diagram showing a receiver according to an embodiment of the present invention. The radio unit shown in Fig. 5 is comprised of a receiver 2 for receiving a reception signal in a radio frequency band from an antenna multiplexer 11 connected to an antenna 1 and frequency-converting the reception signal into a baseband signal, a baseband signal processing section 3, and a transmitter 4. An illustration of functional blocks irrelevant to the present invention is omitted.

The receiver 2 is comprised of an amplifier 21, a switch 22 on the input side, a low-pass filter 23, a high-pass filter 24, a switch 25 on the output side, a frequency converter 26, an IF filter 27, a quadrature demodulating section 28, and a local signal oscillator 29.

The input terminal of the amplifier 21 of the receiver 2 is connected to the reception signal output terminal of the antenna multiplexer 11. The output terminal of the amplifier 21 is connected to the input terminal of the switch 22. One of the two output terminals of the switch 22 is connected to the input terminal of the low-pass filter 23, and the other output terminal is connected to the input terminal of the high-pass filter 24. The output terminals of the low-pass filter 23 and high-pass filter 24 are respectively connected to the input terminals of the switch 25. The switching signal input terminals of the switches 22 and 25 are connected to a switching signal output terminal S of the baseband signal processing section 3. The output terminal of the switch 25 is connected to the RF band input terminal of the frequency converter 26.

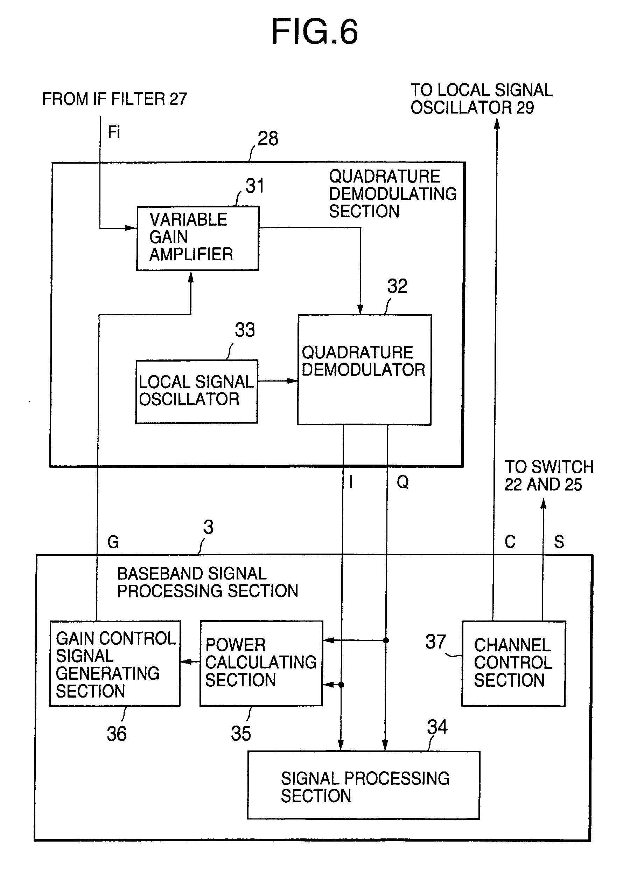

The output terminal of the local signal oscillator 29 is connected to the local signal input terminal of the frequency converter 26. The IF band output terminal of the frequency converter 26 is connected to the input terminal of the IF filter 27. The output terminal of the IF filter 27 is connected to the input terminal of the quadrature demodulating section 28. Connection of the input and output terminals of the quadrature demodulating section 28 will be described later with reference to Fig. 6.

The amplifier 21 is a broadband amplifier for receiving a signal in the RF band which is received through the antenna 1 and divided by the bandpass filter of the antenna multiplexer 11 and amplifying the received signal. The switches 22 and 25 switch the passing route of a reception signal input from the amplifier 21 to one of the low-pass filter 23 and high-pass filter 24 in accordance with a reception frequency Fr of the reception signal and output the signal to the frequency converter 26 under the control of the baseband signal processing section 3. The low-pass filter 23 passes only signal components in a lower frequency band of two divided reception frequency bands. The high-pass filter 24 passes only signal components in a higher frequency band of the two divided reception frequency bands.

The frequency converter 26 receives a channel-set reception signal (frequency Fr) in the RF band from the switch 25, and frequency-converts it into a reception signal (frequency Fi) in an IF band by using a local signal (frequency F1) separately received from the local signal oscillator 29. The IF filter 27 passes only a reception signal (frequency Fi) in the IF band received from the frequency converter 26. The quadrature demodulating section 28 is feedback-controlled by the baseband signal processing section 3 and controls the levels of signals received from the IF filter 27 to become constant, thereby quadrature-demodulating the reception signal in the IF band. The quadrature demodulating section 28 also frequency-converts the reception signal into a baseband reception signal and sends it out to the baseband signal processing section 3.

The quadrature demodulating section 28 and baseband signal processing section 3 will be additionally described next with reference to Fig. 6 in addition to Fig. 5.

As shown in Fig. 6, the quadrature demodulating section 28 is comprised of a variable gain amplifier 31, quadrature demodulator 32, and local signal oscillator 33. The baseband signal processing section 3 is comprised of a signal processing section 34, power calculating section 35, gain control signal generating section 36, and channel control section 37.

The input terminal of the variable gain amplifier 31 of the quadrature demodulating section 28 is connected to the output terminal of the IF filter 27. The input terminal of the variable gain amplifier 31 for a gain control signal G is connected to the output terminal of the baseband signal processing section 3 for the gain control signal G. The output terminal of the variable gain amplifier 31 is connected to the IF band input terminal of the quadrature demodulator 32. The local signal input terminal of the quadrature demodulator 32 is connected to the output terminal of the local signal oscillator 33. The I and Q component output terminals of the quadrature demodulator 32 are respectively connected to the I and Q component input terminals of the baseband signal processing section 3.

In the quadrature demodulating section 28, the variable gain amplifier 31 controls the gain of a reception signal received from the IF filter 27 in accordance with the gain control signal G received from the gain control signal generating section 36, and outputs the resultant signal to the quadrature demodulator 32. The quadrature demodulator 32 frequency-converts the reception signal in the IF band into a baseband reception signal by using the input reception signal and the local signal output from the local signal oscillator 33. In addition, the quadrature demodulator 32 quadrature-demodulates the reception signal and outputs the resultant signals as I and Q component reception signals to the signal processing section 34 and power calculating section 35 of the baseband signal processing section 3.

In the baseband signal processing section 3, the signal processing section 34 performs signal processing such as error correction for the input reception signal, and then extracts data such as speech or image data. The power calculating section 35 calculates the power of the reception signal input from the quadrature demodulator 32, and outputs the calculation result to the gain control signal generating section 36.

If the power calculation result input from the power calculating section 35 is large, the gain control signal generating section 36 controls the variable gain amplifier 31 by generating the gain control signal G for reducing the gain of the variable gain amplifier 31. On the other hand, if the input power calculation result is small, the gain control signal generating section 36 controls the gain of the variable gain amplifier 31 by generating the gain control signal G for increasing the gain of the variable gain amplifier 31. As a consequence, the gain of the variable gain amplifier 31 controls the power of each reception signal input to the baseband signal processing section 3 to become constant.

The channel control section 37 sets a reception channel and executes route switching control on the switches 22 and 25. Switching of the switches 22 and 25 is controlled as follows. If a reception channel is on the low-frequency side in the reception frequency band, the route of the low-pass filter 23 is selected. If a reception channel is on the high-frequency side in the reception frequency band, the route of the low-pass filter 24 is selected.

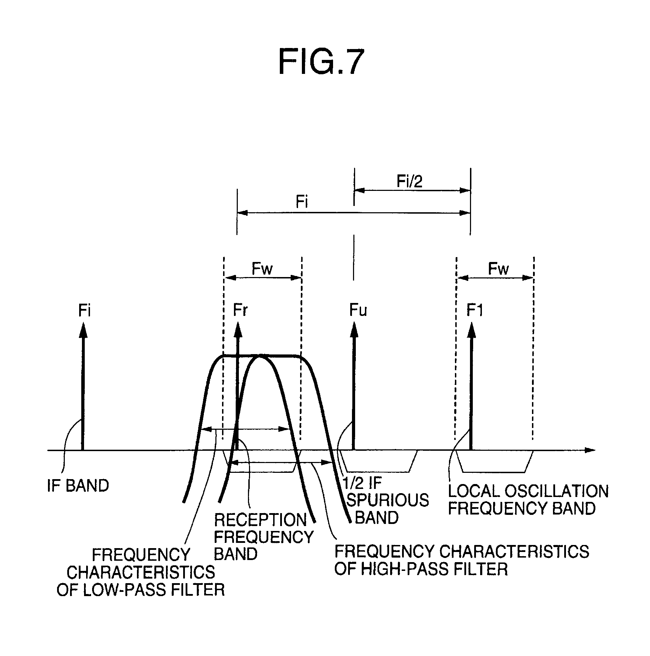

The operation of this embodiment and the functions implemented by the operation will be described next with reference to Fig. 7 in addition to Figs. 5 and 6.

Referring to Fig. 5, first of all, a signal transmitted from a base station (not shown) is received by the antenna 1. The reception signal received by the antenna 1 is input to the amplifier 21 through the antenna multiplexer 11. The antenna multiplexer 11 passes only a reception signal (frequency Fr) in a predetermined frequency range, and cuts off interference waves other than the reception signal. The amplifier 21 amplifies the reception signal with a predetermined gain and outputs the amplified signal.

The switches 22 and 25 are subjected to switching control by the channel control section 37 of the baseband signal processing section 3 such that if the frequency Fr of the reception signal is on the low-frequency side in the reception frequency band, the route of the low-pass filter 23 is selected, whereas if the frequency Fr of the reception signal is on the high-frequency side in the reception frequency band, the route of the high-pass filter 24 is selected.

The reception signal (frequency Fr) output from the amplifier 21 is input to the switch 22. As described above, if the frequency Fr of the reception signal is on the low-frequency side in the reception frequency band, the signal is input from the switch 22 to the frequency converter 26 through the route of the low-pass filter 23 and the switch 25. If the frequency of the reception signal is on the high-frequency side in the reception frequency band, the reception signal is input from the switch 22 to the frequency converter 26 through the route of the high-pass filter 24 and the switch 25.

The frequency converter 26 frequency-converts the reception (frequency Fr) in the RF band into a reception signal (frequency Fi) in the IF band by using the input reception signal (frequency Fr) and the local oscillation signal (frequency F1) output from the local signal oscillator 29 as indicated by equation (1), and outputs the reception signal. The reception signal (frequency Fi) output from the frequency converter 26 is input to the variable gain amplifier 31 of the quadrature demodulating section 28 through the IF filter 27.

The reception signal output from the variable gain amplifier 31 is input to the power calculating section 35 of the baseband signal processing section 3 through the quadrature demodulator 32. The power calculating section 35 calculates the power value of the input reception signal, and notifies the variable gain amplifier 31 of the power value. The variable gain amplifier 31 generates the gain control signal G for keeping the power of each input reception constant and sends it out to the variable gain amplifier 31, thereby controlling its variable gain. As a consequence, as described above, the variable gain amplifier 31 can amplify the reception signal with a predetermined gain and output the amplified signal to the quadrature demodulator 32.

Fig. 7 shows the IF band corresponding to the frequency Fi, the reception frequency band corresponding to the range of the frequency Fr received by the receiver 2, the 1/2 IF spurious band corresponding to the range of an interference frequency Fu, and the local oscillation frequency band corresponding to the range of the frequency F1.

The IF band does not have a bandwidth exceeding a channel width in order to extract only a reception channel. However, each of the reception frequency band, 1/2 IF spurious band, and local oscillation frequency band has the same bandwidth Fw as the bandwidth Fw of the reception frequency band to ensure a communication line or communication capacity.

This is because when the intermediate frequency Fi is fixed in equation (1), the local oscillation frequency F1 changes in accordance with the moving range of the reception frequency Fr. That is, upon reception of a control signal C from the channel control section 37, the local signal oscillator 29 supplies the local oscillation frequency F1, which is higher than the channel-set reception frequency Fr by the intermediate frequency Fi, to the frequency converter 26.

Under such a condition, in order to avoid a second harmonic wave of the output frequency Fui which falls within the band of intermediate frequencies Fi represented by equation (4), the interference frequency Fu indicated by equation (2) may be avoided.

As shown in Fig. 7, when the reception frequency Fr is on the low-frequency side in the reception frequency band, since the frequency F1 of a local oscillation signal also exists on the low-frequency side in the local oscillation frequency band, the frequency Fu of an interference wave in the 1/2 IF spurious band also exists on the low-frequency side in the 1/2 IF spurious band. However, since the reception frequency Fr on the low-frequency side is received by using the low-pass filter 23, it can be expected that the 1/2 IF spurious band is sufficiently cut off by the low-pass filter 23. This therefore makes it possible to prevent a deterioration in reception sensitivity due to 1/2 IF spurious component.

In the case shown in Fig. 7, in the frequency characteristics of the high-pass filter 24, the interference frequency Fu in the 1/2 IF spurious band is out of the band. In this case, even if the high-pass filter has frequency characteristics in the 1/2 IF spurious band on the high-frequency side, since the interference frequency Fu with respect to the reception frequency Fr on the high-frequency side is also produced on the high-frequency side in the 1/2 IF spurious band, interference waves in the signal having the reception frequency Fr which passes through the high-pass filter 24 can be satisfactorily cut off.

According to the above description, the frequency range of the reception frequency bandpass filter for a reception signal is divided into the low-frequency side and the high-frequency. If the intermediate frequency Fi is low, the local oscillation frequency band on the high-frequency side inevitably approaches the reception frequency band. In this case, since the 1/2 IF spurious band overlaps the reception frequency band, many reception frequency bandpass filters each having a small bandwidth from the low-frequency side to the high-frequency side can be used.

**Claims**

1. A method of avoiding a band interference wave which is produced in a receiver when a reception frequency used for radio communication is converted into a fixed intermediate frequency by using an oscillation frequency of a local signal oscillator, wherein when a frequency of a reception signal is on a low-frequency side in a reception frequency band, channel setting and route switching control are so performed as to make the reception signal pass through a low-pass filter.

2. A method of avoiding a band interference wave which is produced in a receiver when a reception frequency used for radio communication is converted into a fixed intermediate frequency by using an oscillation frequency of a local signal oscillator, comprising the steps of setting bandwidths of a plurality of bandpass filters for dividing a band of reception frequencies such that a frequency of a band interference wave produced by the oscillation frequency of the local signal oscillator falls outside a pass band, and switching one of the plurality of bandpass filters to a bandpass filter corresponding to the frequency of the reception signal.

3. A method according to claim 2, wherein the frequency outside the pass band is a frequency obtained by adding a frequency 1/2 an intermediate frequency to a lowest frequency in each of the bands of the bandpass filters.

4. A circuit for avoiding a band interference wave which is produced in a receiver when a reception frequency used for radio communication is converted into a fixed intermediate frequency by using an oscillation frequency of a local signal oscillator, comprising bandpass filters for dividing the band of reception frequencies into a plurality of narrow bands, and a switch for switching said bandpass filters in accordance with a reception frequency of a reception signal corresponding to a set channel, wherein said plurality of bandpass filters respectively have frequency characteristics which set bandwidths such that a frequency of a band interference wave produced by the oscillation frequency of said local signal oscillator falls outside a pass band.

5. A circuit according to claim 4, wherein each of the bandwidths of said plurality of bandpass filters is set such that a frequency obtained by adding a frequency 1/2 an intermediate frequency to a lowest frequency in each of the bands falls outside the pass band.

**6.** A circuit for avoiding a band interference wave which is produced in a receiver when a reception frequency used for radio communication is converted into a fixed intermediate frequency by using an oscillation frequency of a local signal oscillator, comprising:

a plurality of bandpass filters which divide a band of reception frequencies into a plurality of narrow bands, and respectively have bandwidths set such that a frequency obtained by adding a frequency 1/2 the intermediate frequency to a lowest reception frequency in each band falls outside a pass band;
a switch for switching said bandpass filters in accordance with a reception frequency; and
a local signal oscillator for generating a fixed intermediate frequency by changing a generated oscillation frequency in accordance with a reception frequency.

# FIG.1 PRIOR ART

110

111

ANTENNA MULTIPLEXER

120

RECEIVER

AMPLIFIER — 121

Fr

RECEPTION FREQUENCY
BANDPASS FILTER — 122

123

FREQUENCY
CONVERTER

F1

LOCAL SIGNAL
OSCILLATOR

124

Fi 125

126

IF FILTER

QUADRATURE
DEMODULATING
SECTION

140

TRANS-
MITTER

130

G

BASEBAND SIGNAL
PROCESSING SECTION

# FIG.2 PRIOR ART

IF BAND

RECEPTION
FREQUENCY
BAND

1/2 IF
SPURIOUS
BAND

LOCAL OSCILLATION
FREQUENCY BAND

FREQUENCY CHARACTERISTICS OF RECEPTION
FREQUENCY BANDPASS FILTER

# FIG.3 PRIOR ART

INPUT

Fr

SWITCH — 201

LOW-PASS FILTER — 202     HIGH-PASS FILTER — 203

SWITCH — 204

BROADBAND AMPLIFIER — 205

1st FREQUENCY CONVERTER — 206     1st LOCAL SIGNAL OSCILLATOR — 207

Fil, Fih

IF FILTER — 211

Fi1

2nd FREQUENCY CONVERTER — 212     2nd LOCAL SIGNAL OSCILLATOR — 213

Fi2

OUTPUT

220 — CONTROL SECTION

# FIG.4A PRIOR ART

Fu

Fr

FREQUENCY
CHARACTERISTICS OF
LOW-PASS FILTER 202

Fil/2

# FIG.4B PRIOR ART

FREQUENCY
CHARACTERISTICS OF
HIGH-PASS FILTER 203

Fr

Fu

Fih/2

# FIG.4C PRIOR ART

FREQUENCY
CHARACTERISTICS
OF IF FILTER 211

Fil

Fih

(Fi1)

# FIG.5

# FIG.6

FROM IF FILTER 27

TO LOCAL SIGNAL
OSCILLATOR 29

Fi

28

QUADRATURE
DEMODULATING
SECTION

31

VARIABLE
GAIN
AMPLIFIER

32

33

LOCAL SIGNAL
OSCILLATOR

QUADRATURE
DEMODULATOR

TO SWITCH
22 AND 25

I   Q

G

3

C   S

BASEBAND SIGNAL
PROCESSING SECTION

GAIN CONTROL
SIGNAL
GENERATING
SECTION

POWER
CALCULATING
SECTION

37

CHANNEL
CONTROL
SECTION

36

35

34

SIGNAL PROCESSING
SECTION

# FIG.7

Fi/2

Fi

Fw

Fw

Fi

Fr

Fu

F1

IF BAND

1/2 IF
SPURIOUS
BAND

LOCAL OSCILLATION
FREQUENCY BAND

RECEPTION
FREQUENCY
BAND

FREQUENCY
CHARACTERISTICS
OF LOW-PASS FILTER

FREQUENCY CHARACTERISTICS
OF HIGH-PASS FILTER